Europäisches Patentamt

European Patent Office

Office européen des brevets

(11) Veröffentlichungsnummer: **0 479 008 A2**

## (12) EUROPÄISCHE PATENTANMELDUNG

(21) Anmeldenummer: **91115567.9**

(22) Anmeldetag: **13.09.91**

(51) Int. Cl.5: **G01R 15/02**

(30) Priorität: **29.09.90 DE 4030876**

(43) Veröffentlichungstag der Anmeldung:
**08.04.92 Patentblatt 92/15**

(84) Benannte Vertragsstaaten:
**AT BE CH DE GB LI NL**

(71) Anmelder: **SIEMENS AKTIENGESELLSCHAFT**
**Wittelsbacherplatz 2**
**W-8000 München 2(DE)**

(72) Erfinder: **Smutny, Kurt, Dipl.-Ing.**
**Habernhoferweg 1**
**W-8524 Neunkirchen(DE)**

(54) **Strommessanordnung.**

(57) Es ist ein in einem Strompfad (5) anordbarer Widerstand (7) vorgesehen, welchem ein Meßstrompfad (9,9a,9b) parallel geschaltet ist. Der Widerstand (7) und der Meßstrompfad (9,9a,9b) sind thermisch eng im Sinne eines direkten Wärmeaustausches miteinander gekoppelt, wobei beide aus einem Stück Körper (19) geformt sind.

FIG 4

EP 0 479 008 A2

Die Erfindung bezieht sich auf eine Strommeßanordnung mit einem in einem Strompfad anordbaren Widerstand und einem diesem parallel geschalteten Meßstrompfad.

Bei der Stromerfassung in Stromkreisen mit hohen Strömen und hohen Spannungen ist es allgemein bekannt, Meßwandler zu verwenden, die mit einem Bürdenwiderstand beschaltet werden.

Um die Baumaße zu verringern ist bereits im ETZ Bd. 100 (1979) Heft 24, S. 1390 bis 1394 vorgeschlagen worden, den Meßwandler durch einen Nullflußwandler zu ersetzen. Für besonders hohe Ströme muß jedoch zusätzlich in den Stromkreis ein Widerstand als Shunt vorgesehen werden, dessen Spannungsabfall dem Nullflußwandler zugeführt wird.

In der Praxis wurde eine derartige Meßanordnung jedoch nicht verwendet, da die Meßtoleranzen, insbesondere die Anfangstoleranz, nicht den Anforderungen genügten. Eine Beseitigung dieser Fehlerquellen hätte eine Vergrößerung der Baumaße zur Folge, wodurch der beabsichtigte Erfolg nicht erreicht würde. Des weiteren ergeben sich Kontaktprobleme bei den ohnehin geringen Spannungen am Shunt. Ein nachteiliger Einfluß von Thermospannungen ist ebenfalls zu erwarten.

Verbesserungen in Details wurden bei Anordnung nach der DE-PS 33 23 905 und der DE-OS 33 24 224 dadurch erzielt, daß der Widerstand und der Meßstrompfad thermisch gekoppelt wurden. Diese Anordnungen sind jedoch aufwendig in ihrer Herstellung, wobei das Kontaktierungsproblem nach wie vor besteht.

Aufgabe der Erfindung ist es, bei einer Strommeßanordnung der eingangs genannten Art die oben genannten Nachteile zu verhindern.

Die Lösung der Aufgabe gelingt mit einer Strommeßanordnung gemäß Anspruch 1.

Es ist eine Erkenntnis des Erfinders, daß die wesentliche Ursache der oben genannten Nachteile in den Temperatureigenschaften der einzelnen Elemente der Meßanordnung liegt.

Durch die erfindungsgemäße Lösung werden die Toleranzen verringert. Die Meßgenauigkeit wird erhöht. Die verschiedenen Temperatureigenschaften der einzelnen Elemente kompensieren sich quasi gegenseitig. Die gesamte Strommeßanordnung ist in einem Bauteil vereinigt. Die Baugröße ist wesentlich verkleinert. Das Bauteil läßt sich mit nur wenigen einfachen Arbeitsgängen herstellen. Die Herstellung ist dadurch preisgünstig. Da Verbindungsstellen zwischen den einzelnen Elementen der Strommeßanordnung entfallen, werden ungünstige Einflüsse auf die Meßgenauigkeit verhindert und mögliche Fehlerquellen für Kontaktprobleme beseitigt.

Eine vorteilhafte Ausgestaltung der Erfindung ist nach Anspruch 2 und 11 gegeben. Dadurch ist auf einfache Weise eine Verbesserung der Meßgenauigkeit gegeben.

Eine bevorzugte Ausgestaltung der Erfindung ist nach den Ansprüchen 3, 4, 8 und 10 gegeben. Eine derartige Strommeßanordnung kann aufgrund ihres einfachen Aufbaus - einschließlich der Kalibrierung - maschinell, z.B. von einem Automaten, hergestellt werden.

Dabei ist es gemäß Anspruch 12 günstig, wenn der Körper der Strommeßanordnung aus einem homogenen Material gefertigt ist. Für spezielle Anwendungen kann jedoch der Körper einen Bereich unterschiedlichen Materials umfassen. Dadurch können die Meßeigenschaften zusätzlich beeinflußt werden.

Weitere vorteilhafte Ausgestaltung sind in den übrigen Ansprüchen angegeben.

Ausführungsbeispiele der Erfindung werden nachfolgend anhand der Zeichnung beispielhaft näher erläutert. Es zeigen:

FIG 1     Eine Strommeßanordnung mit Wärmekopplung,

FIG 2     eine Weiterbildung der Strommeßanordnung nach FIG 1,

FIG 3     eine Strommeßanordnung in Ausbildung als Körper und

FIG 4     eine Strommeßanordnung nach Art von FIG 3 mit galvanischer Trennstelle.

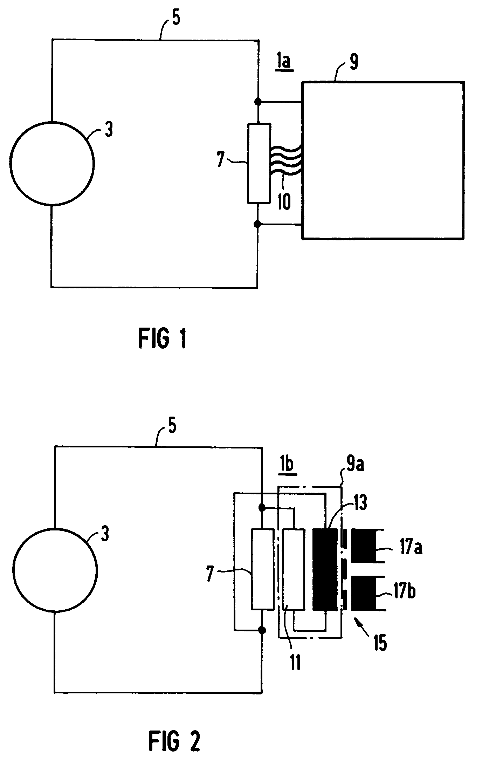

FIG 1 zeigt eine Strommeßanordnung 1a für einen von einer Stromquelle 3 gespeisten Stromkreis 5. In den Stromkreis ist ein als Shunt dienender Widerstand 7 eingefügt. Dem Widerstand 7 ist ein Meßstrompfad 9 parallel geschaltet. Gemäß der vorliegenden Lösung sind der Widerstand 7 und der Meßstrompfad 9 thermisch eng miteinander gekoppelt. Zwischen diesen Elementen findet ein direkter Wärmeaustausch statt. Dies kann z.B. dadurch erfolgen, daß sie in direkter thermischer Berührung miteinander angeordnet sind, wobei die elektrische Isolation gewährleistet sein muß.

FIG 2 zeigt eine Strommeßanordnung 1b nach FIG 1, bei der eine mögliche Ausbildung für den Meßstrompfad 9a gezeigt ist. Dabei ist eine Signalauskoppelstelle vorgesehen, die als galvanische Tennstelle ausgebildet ist. Der gezeigte Meßstrompfad 9a umfaßt dazu eine Reihenschaltung von einem Meßwiderstand 11 und einer Wicklung 13 eines Wandlers 15, insbesondere eines Nullstromwandlers. Der Wandler 15 umfaßt Sekundärwicklungen 17a, 17b und dient als galvanische Trennstelle. Der Wärmeaustausch zwischen den Elementen 13 und 11 des Meßstrompfades 9a und dem Widerstand 7 wird dadurch erzielt, daß sie direkt aneinander angeordnet sind. Die Elemente 11, 13 können auch durch einen nicht näher gezeigten Wärmeleiter, beispielsweise Metall oder ein Wärmeleitmedium, thermisch miteinander gekoppelt sein.

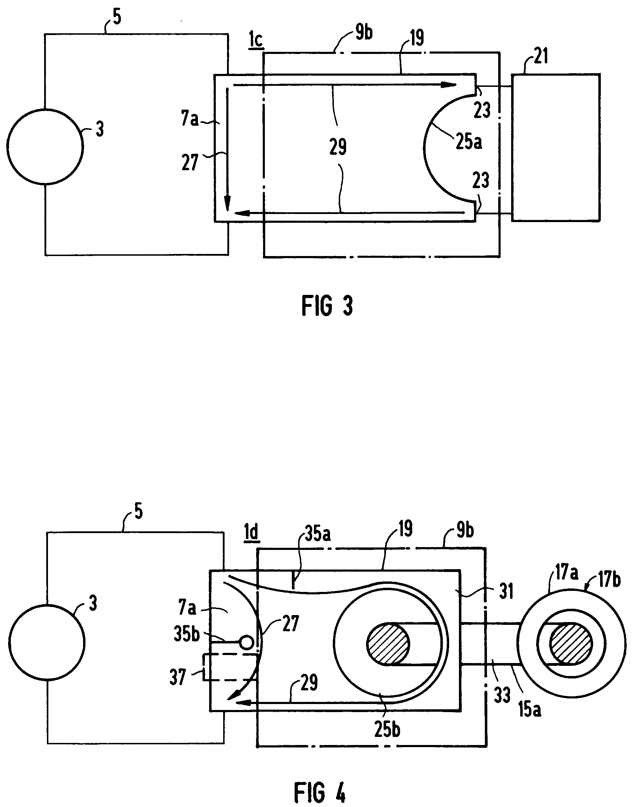

FIG 3 zeigt eine Strommeßanordnung 1c, bei der der Widerstand 7a und der Meßstrompfad 9b von einem Stück leitenden Körper 19 gebildet sind. Die zu einer Meßauswerteschaltung 21 führende Signalauskoppelstelle ist im Sinne eines Spannungsteilers als Abgriff 23 ausgebildet. Der Körper 19 weist eine Ausnehmung 25a auf, so daß im Körper ein zweiteiliger Stromweg entsteht, dessen erster Teil 27 den Stromweg über den Widerstand 7a und dessen zweiter Teil 29 den Stromweg über den Meßstrompfad 9b festlegt. Je nach Dimensionierung von Körper 19 und Ausnehmung 25a werden die elektrischen Werte der Strommeßanordnung 1c bestimmt. Dadurch, daß der Körper 19 aus einem homogenen Werkstoff gefertigt ist, sind die elektrischen Eigenschaften, insbesondere das Temperaturverhalten, der Stromwege 27, 29 gleich. Durch die Zusammenfassung der Elemente zu einem Körper 19 ist der Wärmeaustausch zwischen ihnen voll gegeben.

FIG 4 zeigt eine Strommeßanordnung 1d in der Draufsicht, die eine Signalauskoppelstelle mit galvanischer Trennung umfaßt. Die Ausnehmung 25b ist als Durchbruch ausgebildet, der durch den Körper 19 führt. Die Ausnehmung 25 b bildet zusammen mit dem zweiten Teil des Stromweges 29 die Primärwicklung 31 der galvanischen Trennstelle. An der Primärwicklung 31 ist ein Kern 33 angeordnet, auf dem sich die hintereinander liegenden Sekundärwicklungen 17a, 17b befinden. Die Primärwicklung 31, der Kern 33 und die Sekundärwicklungen 17a, 17b bilden dabei einen Wandler 15a. Zum Kalibrieren ist der Körper mit weiteren Ausnehmungen 35a, 35b versehbar. Durch die Ausnehmungen 35a, 35b, die als einfache Einschnitte in den Körper 19 gemacht sind, sind die Stromwege 27, 29 in ihren elektrischen Werten einstellbar. Auch bei dieser Ausführung ist ein optimaler Wärmeaustausch gegeben. Der Körper 19 kann aus einen homogenen Material gefertigt sein, wobei er aber auch Bereiche unterschiedlichen Materials umfassen kann. Eine derartiger Bereich kann sich z.B. an der Oberfläche des Körpers befinden, so daß ein mehrlagiger Körper 19 gegeben ist. Die Stromwege 27, 29 weisen dabei ein gleiches Temperaturverhalten auf.

Für Strommessungen, bei denen Winkelfehler zu vermeiden sind, kann es günstig sein im Bereich des Widerstandes 7, oder wie in FIG 4 gezeigt, im Bereich des ersten Teils des Stromweges 27 ein Kernstück 37 anzuordnen, das aus einem magnetisch leitenden Material, beispielsweise Eisen, gefertigt ist. Auf diese Weise kann das durch das Streufeld der galvaischen Trennstelle hervorgerufene Nacheilen des Stromes im Meßstrompfad 9b neutralisiert werden.

Da die Übertragungseingenschaften eines Nullflußwandlers von der Permeabilität seines Kernes abhängen, ist es möglich, den Kern 33 mit zumindest einem Luftspalt zu versehen. Auf diese Art kann der Kern 33 als "magnetischer Stecker" ausgebildet werden, der als Koppelglied dient. Im Strompfad 5 verbleibt nur ein Metallstück als Körper 19, der gegenüber einem Stromwandler weder Drähte noch Elektronik enthält.

## Patentansprüche

1. Strommeßanordnung (1a bis d) mit einem in einem Strompfad (5) anordbaren Widerstand (7), sowie einem diesem parallel geschalteten Meßstrompfad (9,9a,9b), wobei der Widerstand (7) und der Meßstrompfad (9) aus einem Stück leitenden Körper (19) geformt sind derart, daß beide thermisch eng im Sinne eines direkten Wärmeaustausches miteinander gekoppelt sind.

2. Strommeßanordnung nach Anspruch 1, wobei das Material des Widerstandes (7) und des Meßstrompfades (9,9a,9b) in direkter thermischer Berührung miteinander angeordnet sind.

3. Strommeßanordnung nach Anspruch 2, wobei der Körper wenigstens eine Ausnehmung (25a,25b) enthält derart, daß ein zweiteiliger Stromweg entsteht, dessen erster Teil (27) den Stromweg über den ersten Widerstand (7) und dessen zweiter Teil (29) den Stromweg über den Meßstrompfad (9,9a,9b) festlegt.

4. Strommeßanordnung nach einem der Ansprüche 1 bis 3, wobei der Meßstrompfad (9) eine Signalauskoppelstelle umfaßt.

5. Strommeßanordnung nach Anspruch 4, wobei die Signalauskoppelstelle im Sinne eines Spannungsteilers als Abgriff (23) ausgebildet ist.

6. Strommeßanordnung nach Anspruch 4, wobei die Signalauskoppelstelle Teil einer galvanischen Trennstelle ist.

7. Strommeßanordnung nach Anspruch 6, wobei die Ausnehmung (25) im Körper (19) als Durchbruch ausgebildet ist.

8. Strommeßanordnung nach Anspruch 7, wobei der Durchbruch zusammen mit dem zweiten Teil des Stromweges (29) die Primärwicklung (31) der galvanischen Trennstelle bildet.

9. Strommeßanordnung nach Anspruch 8, wobei die Primärwicklung (31) zusammen mit einer am Durchbruch angeordneten Sekundärwicklung den Eingang eins Wandlers (15), insbesondere eines Nullflußwandlers, bildet.

10. Strommeßanordnung nach einem der Ansprüche 3 bis 9, wobei zum Kalibrieren der Körper (19) mit einer weiteren Ausnehmung (35a,35b) versehbar ist.

11. Strommeßanordnung nach einem der Ansprüche 1 bis 10, wobei der Widerstand (7) und der Meßstrompfad (9,9a,9b) in ihren elektrischen Eigenschaften gleiche Temperaturverhalten haben.

12. Strommeßanordnung nach einem der Ansprüche 3 bis 11, wobei der Körper (10) aus einem homogenen Werkstoff gefertigt ist.

13. Strommeßanordnung nach Anspruch 12, wobei der Körper (19) zumindest einen Bereich aus einem vom homogenen Werkstoff unterschiedlichen Material umfaßt.

14. Strommeßanordnung nach einem der Ansprüche 4 bis 13, wobei der Meßstrompfad (9) einem Meßwiderstand (11) umfaßt, der mit der Signalkoppelstelle in Serie geschaltet ist.

EP 0 479 008 A2

FIG 1

FIG 2

FIG 3

FIG 4